# FASCICULE DE BREVET EUROPEEN

(11) **EP 0 669 660 B1**
(45) Date de publication et mention de la délivrance du brevet: **28.04.1999**
(21) Numéro de dépôt: 95400390.1
(22) Date de dépôt: 24.02.1995
(51) Int. Cl.: H01L 33/00, H01L 31/0352

(54) **Procédé de tapissage ou de remplissage par dépôt en phase gazeuse d'une structure en relief et application de ce procédé pour la fabrication d'éléments semi-conducteurs**
Verfahren zum Bedecken oder Füllen einer Reliefstruktur durch Abscheidung aus der Gasphase und Verwendung dieses Verfahrens für die Herstellung von Halbleiterbauelementen
Method to cover or fill relief structure by CVD process and use of this method for the fabrication of semiconductor devices

(30) Priorité: 25.02.1994 FR 9402197
(43) Date de publication de la demande: 30.08.1995
(73) Titulaire: FRANCE TELECOM, 75015 Paris (FR)
(72) Inventeur: Bensahel, Daniel, F-38000 Grenoble (FR); Halimaoui, Aomar, F-38000 Grenoble (FR); Badoz, Pierre-Antoine, F-38000 Grenoble (FR); Campidelli, Yves, F-38000 Grenoble (FR)
(74) Mandataire: Casalonga, Axel

(56) Documents cités:
- WO-A-92/19084
- FR-A- 2 564 241
- 5TH INTERNATIONAL CONFERENCE ON SOLID FILMS AND SURFACES. ICSFS-5, PROVIDENCE, RI, USA, 13-17 AUG. 1990, ISSN 0169-4332, APPLIED SURFACE SCIENCE, MAY 1991, NETHERLANDS, PAGE(S) 414 - 418, YASUMATSU T ET AL 'Ultrathin Si films grown epitaxially on porous silicon'
- JOURNAL OF ELECTRONIC MATERIALS, OCT. 1990, USA, VOL. 19, NR. 10, PAGE(S) 1075 - 1081, ISSN 0361-5235, REGOLINI J L ET AL 'Reduced pressure and temperature epitaxial silicon CVD kinetics and applications'
- APPLIED PHYSICS LETTERS, 9 NOV. 1992, USA, VOL. 61, NR. 19, PAGE(S) 2350 - 2352, ISSN 0003-6951, FATHAUER R W ET AL 'New class of Si-based superlattices: alternating layers of crystalline Si and porous amorphous Si/sub 1-x/Ge/sub x/ alloys'
- CHEMICAL PERSPECTIVES OF MICROELECTRONIC MATERIALS III SYMPOSIUM, CHEMICAL PERSPECTIVES OF MICROELECTRONIC MATERIALS III, BOSTON, MA, USA, 30 NOV.-3 DEC. 1992, 1993, PITTSBURGH, PA, USA, MATER. RES. SOC, USA, PAGE(S) 281 - 286, AYLETT B J ET AL 'Metallisation and silicidation of porous silicon'

## Description

La présente invention est relative à un procédé de tapissage ou de remplissage d'une structure en relief possédant un grand rapport d'aspect, c'est-à-dire supérieur à 2, de préférence supérieur à 100 et une période très faible, inférieure à 500 nm par des espèces chimiques semi-conductrices, métalliques ou isolantes, ainsi qu'à diverses applications de ce procédé pour la réalisation d'éléments semi-conducteurs.

Par tapissage on entend le recouvrement de la totalité de la surface spécifique développée par la structure par une fine couche. Par remplissage on entend l'étape suivant le tapissage conduisant à des cavités comblées.

Les structures en relief peuvent être réalisées notamment par électrochimie et autres moyens classiques. Ce type de structure est largement utilisé pour la fabrication de dispositifs électroniques, optoélectroniques, microélectroniques...

Parmi ces structures en relief, l'invention bien que conservant un caractère général vise plus particulièrement le silicium poreux, qui est actuellement l'un des semi-conducteurs utilisés en micro-électronique. Le silicium poreux se caractérise par l'existence d'un réseau de pores interconnectés dans une matrice de silicium. La morphologie du réseau de pores ainsi que la porosité peuvent être contrôlés et sont déterminés par les conditions opératoires du procédé de fabrication du silicium poreux.

A l'issue d'un procédé de fabrication classique (attaque électrochimique le plus souvent), le silicium poreux obtenu n'est pas directement exploitable pour certains types d'applications.

Par exemple, parmi les nombreuses propriétés du silicium poreux, on a récemment découvert qu'il présentait une luminescence intense dans le visible et pouvait être avantageusement utilisé pour la fabrication de diode électroluminescente. Cette luminescence dépend essentiellement du nombre important de nanocrystallites du réseau poreux et du contact établi entre elles. Pour établir un tel contact entre les nanocrystallites d'un réseau de silicium poreux il est intéressant de combler les pores du réseau de façon à recouvrir la totalité de la surface spécifique développée par le réseau poreux.

Pour les applications telles que la réalisation de diodes électroluminescentes, il est nécessaire de réaliser un contact intime au niveau des nanocrystallites du réseau de pores. Il apparaît donc indispensable pour de nombreuses applications de tapisser ou de remplir les cavités ou pores du réseau.

De nombreuses tentatives pour tapisser ou remplir des structures en relief à grand rapport d'aspect ont été faites dans le passé.

Certaines tentatives mettaient en oeuvre notamment des techniques de dépôt par évaporation ou pulvérisation à partir de sources "solides". Ito, Hiraki, Satou, Appl. Surf. Science, 33/34, 1988, 1127-1134 décrit de tels essais effectués sur du silicium poreux en mettant en oeuvre une technique PVD (Physical Vapor Deposition). D'autres essais ont consisté à évaporer des conducteurs sur du silicium poreux, ou de remplir les pores du réseau par des polymères ou des monomères formant des polymères in-situ. Il apparaît que selon ces procédés les rendements d'électroluminescence du silicium poreux résultant sont trop faibles.

D'autres tentatives ont utilisé la surface spécifique développée pour adsorber une espèce chimique par voie gazeuse. Ainsi, certains essais ont notamment consisté à tapisser du silicium poreux en faisant croître une couche de SiO₂. Cette technique consomme néanmoins la matière contenue dans la structure en relief qui dans le cas du silicium entraîne une restructuration incontrôlable et non reproductible du réseau de pores. Par ailleurs, il est connu qu'une restructuration trop forte du réseau de silicium poreux induit une perte de ses capacités de luminescence dans le visible.

Deux autres techniques de tapissage ou de remplissage ont également été réalisées sur le silicium poreux.

A. Bsiesy, F. Muller, M. Ligeon... in "Optical Properties of Low Dimensional Silicon Structures", NATO ASI series, Vol 244, Kluwer Publishers, 1993, pp 139-146 décrit le remplissage des pores de silicium poreux à partir d'une phase liquide. Cette technique permet d'obtenir un bon rendement d'électroluminescence. Toutefois, de telles réalisations ne trouvent que très peu d'applications pratiques du fait de la présence du liquide qui les rend peu maniables. Ces structures présentent également l'inconvénient de vieillir au niveau du silicium poreux ou de l'électrolyte. Le remplissage de silicium poreux par un électrolyte ou un métal est décrit dans le document WO-A-92/19084.

L'article Tsao, Blewer, Tsao, Appl. Phys. Lett., 49(7), 1986, 403-405 décrit le tapissage de silicium poreux par dépôt de tungstène par décomposition en phase gazeuse (CVD : Chemical Vapor Deposition) à basse température. Néanmoins, la réaction de décomposition utilise une partie du silicium contenu dans les crystallites du réseau ce qui entraîne une restructuration incontrôlable du réseau de pores. En outre, la réaction de décomposition est violente et les résultats obtenus difficilement reproductibles.

Une autre méthode de tapissage de silicium poreux par dépôt d'un métal ou/d'un siliciure est décrit dans l'article de B. Aylett et al., Materials Research Society Symposium Proceedings, vol. 282, Chemical Perspectives of Microelectronic Materials III, Boston, US (1992), pages 281 à 286.

Les recherches conduites pour tapisser ou remplir les structures en relief à grand rapport d'aspect n'ont pu fournir de procédés satisfaisants autorisant des applications pratiques de ces structures telles que celle mentionnée précédemment.

L'invention a pour but un procédé de tapissage ou de remplissage de ce type de structures qui ne présentent pas les inconvénients énumérés ci-dessus qui sont notamment une consommation des éléments contenus et une restructuration non contrôlée de la structure.

L'invention a également pour but que les éléments obtenus par un tel procédé puissent être utilisés pratiquement et notamment dans le cas du silicum poreux d'obtenir un rendement d'électroluminescence intense avec une bonne reproductibilité et une bonne maniabilité.

La demanderesse vient de découvrir, ce qui fait l'objet de l'invention, un procédé permettant de tapisser ou de remplir de façon homogène et uniforme une couche de silicium poreux dosée ou non, de porosité contrôlée et possédant un rapport d'aspect élevé, supérieur à 2, de préférence supérieur à 100, en particulier compris entre 100 et 1000, et une période très faible inférieure à 500 nm et pouvant aller jusqu'à 10 nm, caractérisé en ce qu'il consiste à déposer au sein de cette couche de silicium poreux, au moins une espèce chimique semi-conductrice dopée ou non, ou isolante, choisie parmi le silicium, les alliages à base de silicium du type Si_{1-x-y-z-t} Geₓ C_{y} A_{z} Eₜ ; (E)ᵥ avec x, y, z et t désignant une valeur telle que 0 < x + y + z + t < 1 et 0 ≤ x < 1, 0 ≤ y < 1, 0 ≤ z < 1, 0 ≤ t < 1, 0 ≤ v ≤ 1, et v désignant la fraction de E présente éventuellement dans la matière sous forme interstitielle., A désignant un métal et E une terre rare, les oxydes de silicum et les nitrures de silicium, ladite espèce chimique possédant un taux de croissance inférieur ou égal à 10nm/mn par décomposition en phase gazeuse de gaz précurseurs de cette espèce chimique dans un réacteur CVD.

Par ce procédé on recouvre uniformément et de façon homogène, c'est-à-dire sans interruption, la totalité de la surface spécifique développée par la structure. La décomposition en phase gazeuse des gaz précurseurs des espèces à déposer ne nécessite pas l'utilisation d'éléments contenus dans la structure et la réaction est contrôlable, ce qui permet l'obtention de résultats reproductibles.

Le procédé appliqué au silicium poreux permet en outre de fabriquer des diodes électroluminescentes possédant un rendement d'électroluminescence nettement supérieur à ce que l'on obtenait avec les techniques de l'art antérieur. Les dispositifs émetteurs intégrant de telles diodes sont beaucoup plus performants que ceux de l'art antérieur.

Une interprétation peut être avancée pour ces résultats surprenants obtenus avec le procédé de l'invention qui se caractérisent par des propriétés supérieures des structures par rapport à celles de l'art antérieur. Il semblerait que par le procédé de l'invention, on obtienne un tapissage uniforme et homogène, ou encore égal en tous points de la surface spécifique, tout comme l'on obtient si l'on poursuit le procédé un remplissage des cavités sans laisser d'espace vide résiduel dans la structure en relief.

Dans les techniques antérieures évoquées précédemment; on peut penser que les cavités s'obstruaient avant la fin du tapissage ou du remplissage emprisonnant dans le relief des espaces vides résiduels empêchant un bon contact entre les nanocrystallites. Ce phénomène pourrait résulter d'une cinétique de réaction trop importante ou de la grande taille des molécules introduites...

L'objet de la présente invention consiste donc en un procédé pour tapisser ou remplir une structure en relief de grand rapport d'aspect et de période faible par dépôts par décomposition en phase gazeuse ainsi qu'en des éléments composés d'une telle structure tapissée ou remplie selon le procédé de l'invention.

Un autre objet de l'invention réside en des diodes électroluminescentes fabriquées selon le procédé de l'invention et leur utilisation dans des dispositifs émetteurs.

L'invention a également pour objet des multi-puits quantiques pouvant être fabriqué par le procédé de l'invention, et leur utilisation dans des dispositifs détecteurs de lumière.

D'autres objets et caractéristiques de l'invention apparaîtront plus clairement à la lecture de la description et des exemples qui suivent ainsi qu'au vu des figures.

La Fig 1 illustre schématiquement le tapissage d'une structure en relief par un système monocouche.

La Fig 2 illustre schématiquement le remplissage des cavités d'une structure en relief, étape suivant le tapissage

La Fig 3 illustre schématiquement le tapissage d'une structure en relief par une multicouche.

Les Figs 4 à 10 illustrent schématiquement les différentes structures aux différentes étapes de la fabrication d'une diode électroluminescente.

La Fig 11 illustre schématiquement le phénomène supposé de bouchage des pores lors du remplissage selon une méthode de l'art antérieur.

La fig 12 illustre le procédé de fabrication d'une diode électroluminescente selon l'invention.

Le procédé conforme à l'invention, pour tapisser ou remplir de façon uniforme une structure en relief sur un substrat massif, possédant un rapport d'aspect supérieur à 2, et une période très faible inférieure à 500 nm est essentiellement caractérisé par le fait que l'on dépose dans cette structure au moins une espèce chimique semi-conductrice dopée ou non, métallique ou isolante, par décomposition en phase vapeur (CVD) de gaz précurseurs de cette espèce chimique dans un réacteur CVD.

La structure en relief est généralement obtenue par électrochimie et présente des périodes extrèmement petites pouvant atteindre quelques nanomètres.

Selon le procédé de l'invention pour tapisser ou remplir une structure en relief, la réaction de décomposition en phase gazeuse a lieu de préférence à une température de décomposition inférieure ou égale à 750°C et à une pression inférieure ou égale à environ 14 Pa (100 m torrs). La température est comprise de préférence entre 350°C et 600°C, et la pression entre environ 0,07 et 14 Pa (0,5 et 100 m torrs).

Dans le procédé de l'invention, on introduira de préférence les gaz précurseurs de l'espèce chimique que l'on souhaite déposer sur la surface spécifique développée par la structure en relief, avant la montée en température.

Les gaz précurseurs sont choisis en fonction des espèces chimiques à déposer et tous les gaz habituellement utilisés en CVD peuvent être utilisés dans le présent procédé. On valorisera notamment ceux ayant un taux de décomposition ou des pressions de vapeur élevées à des températures inférieures ou égales à 750°C.

On évitera, de préférence, d'utiliser des composés gazeux ou vapeur chlorés ou fluorés pour le transport des espèces chimiques à déposer. Ce sont en effet des gaz réactifs qui peuvent engendrer une restructuration de la structure.

On peut utiliser à titre de gaz précurseurs par exemple SiH₄, Si₂H₆, GeH₄, Si(CH₃)₄, éventuellement en présence de gaz dopants qui peuvent être par exemple B₂H₆ pour un dopage de type P ou PH₃, AsH₃ pour un dopage de type N. Ces gaz peuvent être dilués dans un gaz tel que l'hydrogène à des facteurs de dilution de 10 à 1000.

Ces gaz précurseurs peuvent également être mis en oeuvre avec O₂, NH₃, N₂O ou d'autres gaz nitrés ou oxygénés pour obtenir des dépôts Si O₂ ou d'oxynitrures.

Il est possible enfin de les mettre en oeuvre en mélange dans des quantités très faibles avec des gaz organométalliques ou de terres rares, dans le cas où l'on souhaite introduire de tels composants. Ces gaz sont utilisés dans des proportions extrêmement faibles dans un rapport de dilution par rapport au milieu gazeux inférieur à 1000.

L'espèce ou les espèces chimiques dépendent essentiellement de la nature de la structure en relief sur laquelle elles doivent être déposées, ainsi que de l'usage que l'on souhaite faire de la structure finale. Elle peut être semi-conductrice dopée ou non, les ions dopants étant également introduits par CVD d'un composé gazeux les contenant, métallique, organométallique ou isolante.

Le choix des gaz et des espèces chimiques peut être effectué par l'homme du métier en fonction des propriétés recherchées.

Le temps de la réaction de décomposition dépend essentiellement de la vitesse de croissance de l'espèce à déposer, ainsi que de l'effet souhaité. Le temps de réaction pour une espèce chimique donnée sera plus long pour remplir les cavités d'une structure que pour en tapisser la surface spécifique, et encore plus long si l'on souhaite former une couche épitaxiale sur la structure dont les cavités ont été remplies. En ajustant ce temps de réaction, on peut donc contrôler le tapissage à la monocouche prés.

Le procédé de l'invention permet également en modifiant la nature du mélange gazeux dans le réacteur après le dépôt de la première couche, de superposer sur celle-ci une autre couche par dépôt CVD et éventuellement de réitérer cette opération plusieurs fois de manière à recouvrir la surface spécifique développée d'une multicouche obtenue par dépôts successifs d'espèces chimiques de nature différentes.

Certaines structures en relief sont très sensibles aux conditions opératoires, et ont tendance, par exemple, à se restructurer ce qui comme mentionné précédemment influe sur les propriétés de la structure résultante.

Dans certains cas, il est donc nécessaire de stabiliser les structures sensibles par exemple à la température avant la mise en oeuvre du procédé de l'invention. Pour ce faire, on soumet ces structures à une pré-oxydation avant le tapissage ou le remplissage par l'espèce chimique souhaitée. Cette préoxydation peut également être intéressante pour les structures où l'on souhaite prendre contact sur un oxyde très mince.

Cette préoxydation peut être effectuée rapidement par CVD à une température inférieure ou égale à 550°C. On peut également faire une légère préoxydation sous oxygène à basse température (T ≤ 300°C). Une autre variante consiste à réaliser l'oxydation par voie électrochimique juste après la formation de la structure en relief. Tout autre procédé classique approprié peut être mis en oeuvre pour cette préoxydation.

La structure en relief peut être constituée de tout matériau et notamment d'un semi-conducteur dopé ou non tel des alliages de Si, Ge Si, Si poreux ou gravé.

Comme il a été dit précédemment, ce procédé peut avantageusement être appliqué au tapissage ou remplissage du silicium poreux surmontant ainsi tous les inconvénients survenus jusqu'à présent dans les procédés de l'art antérieur.

Le silicium poreux peut être dopé N ou P, ou ne pas être dopé du tout. La morphologie de son réseau de pores peut être contrôlée par la réaction de formation du poreux. Ce réseau peut être isotrope c'est-à-dire qu'il s'agit d'un réseau aléatoire de pores où les nanocrystallites ne sont pas régulières ni toutes dirigées dans la même direction et s'entremèlent pour conduire à un effet "pelote". Le réseau peut également être anisotrope, c'est-à-dire un réseau de pores ordonné dont les crystallites sont orientées verticalement dans la même direction. Les réseaux anisotropes peuvent être obtenus par lithographie, gravure ainsi que par électrochimie.

La porosité du silicium poreux est contrôlée et déterminée par les conditions opératoires du procédé utilisé pour former la couche poreuse. Elle peut être quelconque. Une porosité typique est comprise entre 50 et 60 % ou supérieure à ces valeurs. Néanmoins, pour certaines applications, on préférera du silicium poreux de porosité supérieure à 75 %, de préférence de 80 à 85 %.

L'épaisseur de la couche poreuse peut être aussi grande que l'on désire. On préfère toutefois une épaisseur de 10 à 1000 nm.

En ce qui concerne les conditions opératoires du dépôt par décomposition en phase gazeuse des espèces chimiques désirées ayant un taux de croissance ≤ 10 nm/mn, on travaille à une pression ≤ 14 Pa (100 m torrs) et à une température ≤ 750°C, de préférence ≤ 600°C, au delà de ces valeurs le silicium poreux à tendance à se restructurer et le dépôt n'est plus homogène et uniforme.

Les gaz précurseurs habituellement utilisés en CVD sur silicium massif peuvent être utilisés dans le présent procédé de dépôt sur silicium poreux. On citera par exemple SiH₄, H₂, GeH₄, Si(CH₃)₄, O₂, NO₂, NH₃ ainsi que des gaz à base des composés organométalliques, de terres rares, et d'autres gaz nitrés, oxygénés... et, pour introduire les dopants, des gaz tels que B₂ H₆, PH₃, AsH₃ et d'autres du même type.

L'espèce chimique déposée dans les cavités ou pores du silicium poreux peut être quelconque semi-conductrice dopée ou non, métallique, organo-métallique ou isolante. On choisira toutefois de préférence des espèces chimiques à base de silicium tels que le silicium; un alliage du type
Si_{1-x-y-z-t} Geₓ C_{y} A_{z} Bₜ ; (B)ᵥ avec x, y, z et t désignant une valeur telle que
0 < x + y + z + t < 1, 0 ≤ x < 1, 0 ≤ y < 1, 0 ≤ z < 1,
0 ≤ t < 1, 0 ≤ v ≤ 1
v correspond à la fraction de terre rare qui peut être présente dans la matrice sous forme interstitielle et non pas substitutionnelle.
A désigne un métal, et
B désigne une terre rare;
les oxydes de silicum tels que par exemple SiO₂, SiOₓN_{y} et les nitrures de silicium tels que par exemple Si₃N₄.

Parmi les métaux que peut désigner A, on citera par exemple W, Ti, Al et autres du même genre. Comme terre rare on citera plus particulièrement l'erbium.

Les espèces chimiques semi-conductrices à base de silicium peuvent être dopées N ou P ou ne pas être dopées du tout.

Selon le procédé de l'invention, on peut tapisser de façon homogène et uniforme la totalité de la surface spécifique développée par le silicium poreux d'une monocouche d'une espèce chimique telle que définie précédemment ou d'une multi-couches constituée de plusieurs couches régulières superposées d'espèces chimiques différentes telles que définies précédemment et résultant du dépôt successif d'espèces chimiques de nature différente.

On peut ainsi obtenir par exemple des multi-couches composées d'une alternance de couches de silicium et d'un alliage à base de silicium tel que défini précédemment ou de couches d'autres espèces chimiques.

Selon le procédé de l'invention, on peut également remplir les pores du silicium poreux sans laisser subsister aucun espace vide dans la couche poreuse. Ces caractéristiques permettent d'utiliser avantageusement le procédé de l'invention pour la fabrication de diodes électroluminescences à base de silicium poreux, possédant des rendements d'électroluminescence très supérieurs à ceux obtenus avec des diodes à base de silicium poreux fabriquées selon les procédés de l'état de la technique.

Pour la fabrication de ces diodes électroluminescentes, on utilise du silicium poreux dopé, de préférence P, présentant une porosité supérieure ou égale à 65 %, de préférence de 80 à 85 %.

Le silicium poreux possédant une telle porosité est très sensible à la température et a tendance à fortement se restructurer. On soumettra donc de préférence, les plaquettes de ce silicium poreux à une préoxydation selon les méthodes énoncées plus haut, avant le dépôt par CVD des espèces chimiques souhaitées. La réalisation de la couche d'oxyde par électrochimie permet une oxydation par le fond des pores ce qui possède l'avantage d'éviter les courts-circuits au niveau du substrat tout en profitant d'un contact non oxydé à la surface supérieure.

Les mélanges gazeux des gaz précurseurs de l'espèce chimique à déposer comprennent des gaz tels que PH₃ et AsH₃ introduisant un dopant N pour le silicium. Parmi toutes les espèces chimiques utilisables pour le dépôt CVD sur silicium poreux définies précédemment, on citera par exemple le silicium pur ou un alliage du type Si₁₋ₓGeₓ avec 0 < x < 1) dopé N si le silicium poreux est dopé P.

On recouvre la totalité de la surface spécifique développée par le silicium poreux jusqu'à ce que les pores soient remplis. On poursuit la réaction de dépôt CVD jusqu'à la formation d'une couche épitaxiale sur le réseau de pores comblées afin de pouvoir prendre un contact sur le matériau anciennement poreux.

On dépose ensuite sur cette couche épitaxiale un conducteur pour obtenir une diode N - P électroluminescente. Si le dépôt du conducteur est fin, après polarisation, la structure se comportant comme une diode N - P émettra de la lumière à travers le plot de contact. Si l'on dépose un conducteur épais, on grave en peigne la structure d'où, après passivation avec de l'oxyde, sortira la lumière le long du périmètre développé.

Le dopage peut être inversé, à savoir que le silicium poreux peut être dopé N et l'espèce chimique à déposer peut être dopée P. Auquel cas on introduira dans le réacteur un gaz contenant un dopant P pour le silicium tel que B₂H₆.

La diode ainsi obtenue constituant également l'objet de l'invention pourra être intégrée dans un dispositif émetteur de lumière.

Le procédé de l'invention permet également avantageusement la réalisation de certains systèmes émetteurs qui pouvaient difficilement être obtenus jusqu'à présent par les méthodes classiques. Ces émetteurs présentent une émission améliorée à certaines longueurs d'onde par rapport aux faibles émissions observées avec des émetteurs de l'art antérieur.

Le carbone, par exemple, émet à une longueur d'onde de 1,3 µm. Or, on a constaté que lorsqu'une structure massive à base de silicium comportait plus d'1 % de carbone, celui-ci précipitait dans la structure. Par le procédé de l'invention, il est possible de recouvrir la totalité de la surface spécifique développée par du silicium poreux par des espèces chimiques quelconques. La surface spécifique développée par du silicium poreux est 100 à 1 milliard de fois supérieure à celle du silicium massif. Le procédé de l'invention conduit donc à la formation sur cette grande surface d'un alliage du type Si_{1-x-y-z-t} Geₓ C_{y} A_{z} Bₜ ; (B)ᵥ dans lequel A, B, x, y, z, t, v ont les mêmes significations que celles mentionnées ci-dessus.

Ce qui permet l'introduction dans le silicium poreux d'une plus grande quantité de carbone à travers une mince couche d'alliage développée sur toute la surface spécifique que si l'on utilise du silicium massif de même surface extérieure comme substrat. L'émission d'une telle structure à une longueur d'onde de 1,3 µm est plus forte qu'avec les systèmes classiques.

Il en est de même pour l'erbium qui émet à une longueur d'onde de 1,54 µm. Jusqu'à présent il était difficile d'introduire de l'erbium dans un réseau de silicium massif. En introduisant de l'erbium par tapissage de la surface spécifique développée par du silicium massif, selon le procédé de l'invention, il est possible d'obtenir un émetteur à 1,54 µm possédant une émission accentuée par rapport au silicium massif de même surface extérieure.

D'autres substances émettrices peuvent être introduites dans le silicium poreux par la mise en oeuvre du procédé selon l'invention permettant d'accentuer les émissions aux longueurs d'ondes de ces substances émettrices par rapport aux émetteurs fabriqués à partir de substrats massifs correspondants.

L'invention a également pour objet des multi-puits quantiques constitués d'une structure en relief possédant un rapport d'aspect élevé supérieur à 2 et de préférence supérieur à 100 et une période inférieure à 500 nm dont la totalité de la surface spécifique développée est tapissée d'au moins une couche d'une espèce chimique semi-conductrice dopée ou non, métallique ou isolante. Cette structure peut être obtenue notamment par électrochimie.

Le dépôt d'une monocouche ou d'une multicouche sur la totalité de la surface spécifique développée par la structure en relief, peut être effectuée par la mise en oeuvre du procédé de l'invention, mais ne se limite pas à ce seul procédé. Comme structure en relief, on citera par exemple le silicium poreux de porosité quelconque, et de préférence typique de 50 à 60 % ou supérieure, possédant un réseau de pores isotrope ou anisotrope.

De tels multi-puits quantiques et notamment lorsque la structure est du silicium poreux et que l'espèce chimique déposée un alliage à base de silicium, et plus particulièrement un alliage de type Si₁₋ₓ Geₓ avec x et 0 < x < 1, présentent un rendement d'absorption très supérieur au rendement obtenu avec les multi-puits quantiques "traditionnels" obtenus par empilage vertical d'une succession de couches composées notamment de Si₁₋ₓ Geₓ et de Si déposées par CVD.

On préférera utiliser du silicium poreux possédant un réseau de pore isotrope afin de permettre une absorption multi-directionnelle. Les multi-puits quantiques multi-directionnels ainsi fabriqués simplifient et augmentent les potentialités des détecteurs par exemple infrarouges dont ils constituent l'élément essentiel en permettant une détection sous incidence quelconque ainsi que des rendements de détection améliorés.

En alternant le dépôt d'espèces chimiques différentes sur la surface spécifique développée par la structure en relief de façon à la tapisser d'une multicouches on fabrique des hétéro-puits quantiques.

On peut par exemple alterner des dépôt de silicium et d'un alliage de Si₁₋ₓ Geₓ avec x (0 < x < 1). On obtient ainsi des hétéro-multipuits quantiques constitués par du silicium poreux tapissé d'une multi-couche composée d'une alternance de couches de silicium et de couches de Si Ge.

Pour la fabrication de multi-puits quantiques détecteurs de lumière, les multi-puits quantiques traditionnels obtenus par empilage vertical de couches déposées par CVD doivent au moins comporter 50 couches successives pour réaliser une absorption suffisante dans la bande complète de 9 à 12 µm. Avec les multi-puits quantiques selon l'invention, le dépôt par CVD d'une seule couche est suffisante pour une absorption complète dans la même bande. Ceci réduit considérablement le temps de fabrication des multi-puits quantiques passant de plus d'une heure à quelques minutes au maximum. En outre, le tapissage des structures en relief par une monocouche est contrôlé une fois et permet l'obtention d'une couche uniforme et homogène d'épaisseur constante le long de toute la surface spécifique développée. Lors de la fabrication de multi-puits quantiques traditionnels, il était nécessaire de contrôler l'épaisseur de chacune des couches déposées.

Ces multi-puits quantiques peuvent constituer l'élément essentiel d'un détecteur de lumière tel qu'un détecteur infra-rouge possédant un rendement de détection supérieur à ceux contenant des multi-puits traditionnels. En outre, on peut fabriquer des détecteurs multi-directionnels en utilisant des multi-puits quantiques fabriqués à base de silicium poreux possédant un réseau de pore isotrope.

Certaines caractéristiques et modes de réalisation de l'invention apparaîtront plus clairement à la lecture de la description des figures.

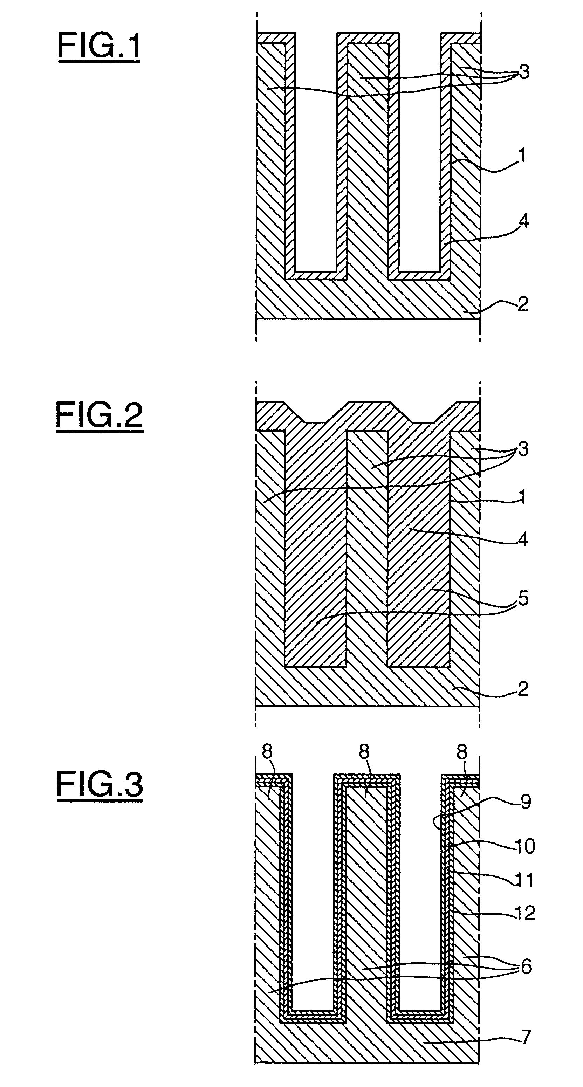

La figure 1 représente schématiquement une structure en relief (1) formée sur un substrat massif (2) par un procédé classique tel que par exemple l'électrochimie, et dont les crystallites (3) sont toutes orientées verticalement dans le même sens. Cette structure a été tapissée selon le procédé de l'invention par dépôt d'une substance chimique formant une monocouche (4) recouvrant de façon homogène et uniforme la totalité de la surface spécifique développée par la structure sans aucune interruption.

Une telle structure peut avantageusement être utilisée comme multi-puits quantiques dans un détecteur de lumière.

La figure 2 constitue l'étape suivant celle de la figure 1 lorsque l'on augmente le temps de réaction. Cette figure représente la structure en relief (1) formée sur le substrat massif (2) par des méthodes classiques telles que l'électrochimie, et dont les crystallites (3) sont toutes orientées verticalement dans la même direction. Les cavités (5) de cette structure sont remplies par la substance chimique (4) selon le procédé de l'invention de façon à ne laisser subsister aucun espace vide dans la structure.

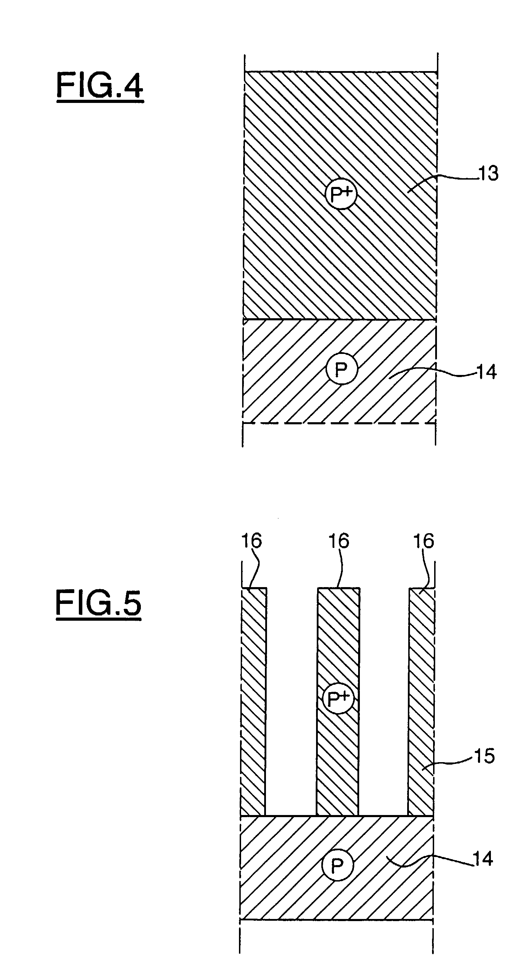

La figure 3 représente une structure en relief (6) formée sur un substrat massif (7) selon un procédé classique tel que par exemple l'électrochimie, et dont les crystallites (8) sont orientées verticalement dans la même direction. Cette structure a été tapissée selon le procédé de l'invention en alternant des dépôts successifs d'espèces chimiques différentes. La surface spécifique développée par cette structure est recouverte d'une multi-couche (9) constituée d'une superposition de couches de nature différentes (10), (11) et (12). Cette multi-couche est en tout point de la surface spécifique développée de même épaisseur et de même constitution. Une telle multi-couche peut être obtenue selon le procédé de l'invention en modifiant après chaque dépôt la composition du mélange de gaz précurseurs dans le réacteur. On soumet ensuite la structure tapissée du dépôt précédent à un nouveau dépôt par décomposition en phase gazeuse d'une nouvelle espèce chimique selon le procédé de l'invention. Cette opération peut être répétée autant de fois que l'on désire de couches différentes composant la multi-couche.

Une telle structure peut avantageusement être utilisée comme hétéro-multi-puits quantiques dans un détecteur de lumières.

Les figures 4 à 10 représentent chacune schématiquement la structure résultante à chacune des étapes d'un procédé de fabrication d'une diode électroluminescente à base de silicium poreux.

On peut également réaliser une telle diode électroluminescente en inversant le type de dopage (substrat N, poreux N ou N⁺, et replissage de type P ou P⁺).

La figure 4 illustre la première étape dans laquelle on épitaxie une couche de silicium dopée P⁺ (13) sur un substrat de silicium massif dopé P (14).

Selon la figure 5, on forme une couche poreuse (15) dans la couche épitaxiale (13) selon des méthodes classiques telles que par exemple par l'électrochimie, la lithographie, la gravure, de façon à obtenir une couche poreuse (15) dont les crystallites (16) sont toutes orientées de préférence verticalement. L'orientation peut être dans la même direction.

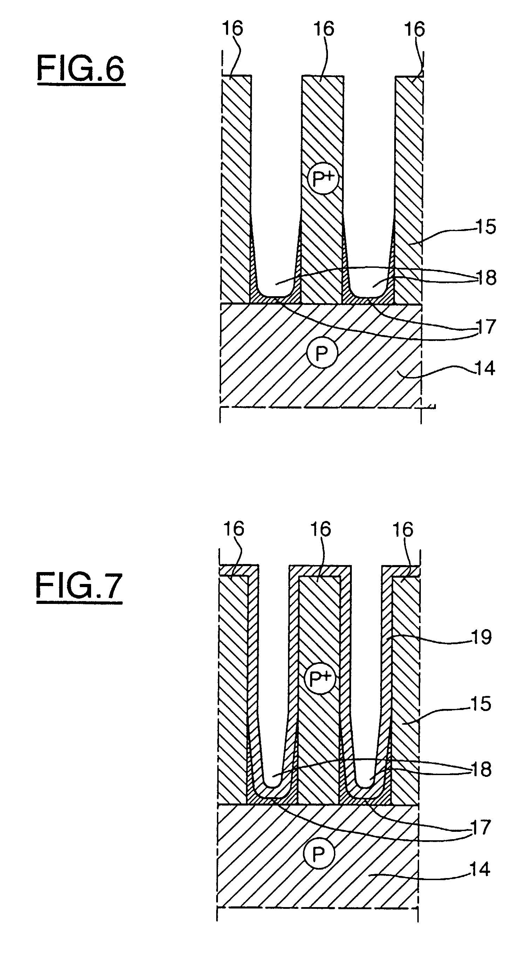

La figure 6, représente la structure après sa stabilisation par une préoxydation. Cette préoxydation a été effectuée par une oxydation anodique qui n'a oxydé que le fond des cavités (18), créant une fine couche de SiO₂ (17). Cette préoxydation stabilise la structure et évite également tout court-circuit éventuel avec le substrat (14).

La figure 7 montre le silicium poreux (15) tapissé par dépôt CVD d'une espèce chimique dopée N selon le procédé de l'invention. Il en résulte que la surface spécifique développée par le silicium poreux (15) comportant au fond des pores (18) un dépôt de SiO₂ (17), est recouverte d'une mono-couche (19) homogène, uniforme et de même épaisseur en tout point de la surface.

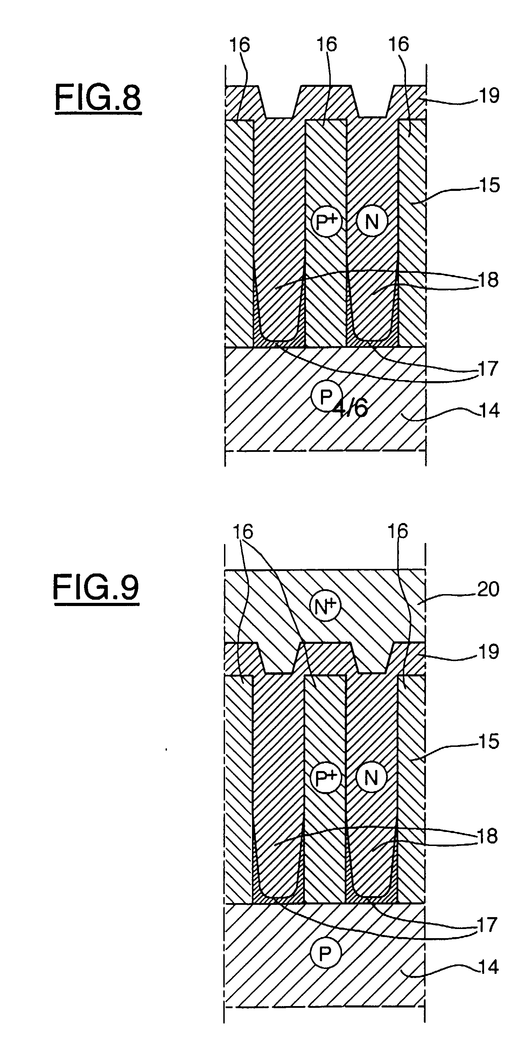

La figure 8 représente le silicium poreux soumis à un temps de réaction plus long selon le procédé de l'invention de façon à remplir les pores (18) de l'espèce chimique dopée N (19). Le silicium poreux résultant à ses pores comblés de façon homogène et uniforme sans laisser subsister d'espace vide dans le réseau de pore.

La figure 9 illustre l'étape suivante qui consiste à épitaxier sur le silicium poreux (15) dont les pores (18) ont été comblés, une couche (20) de même espèce chimique dopée N⁺. Cette épitaxie est réalisée en augmentant le temps de réaction par rapport à celui nécessaire pour le remplissage. En ajustant ce temps de réaction, on obtient une couche épitaxiale de l'épaisseur voulue.

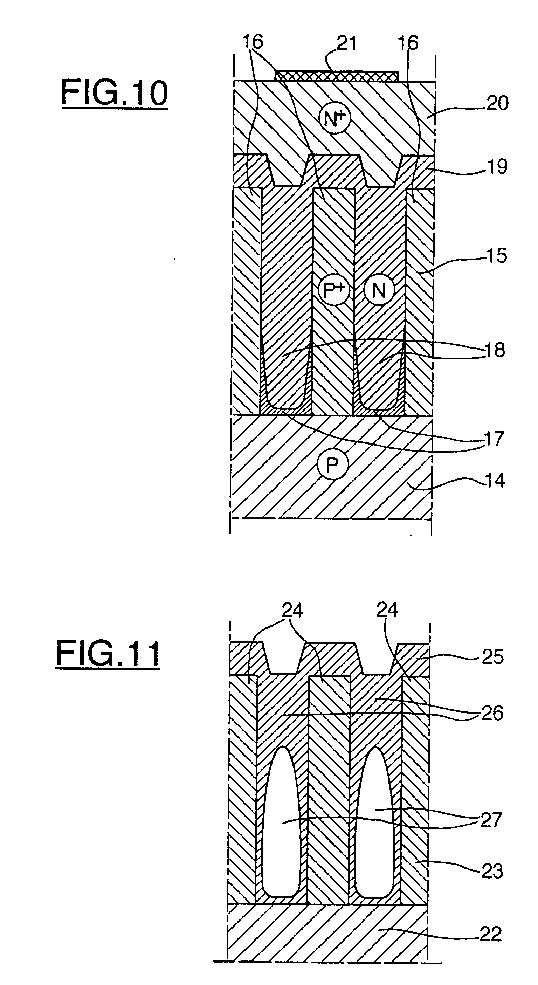

La figure 10 illustre la dernière étape de ce procédé de fabrication d'une diode électroluminescente qui consiste à déposer sur la couche épitaxiale formée précédemment un conducteur (21). Si le dépôt de de conducteur (21) est fin, après polarisation, la structure se comporte comme une diode N-P et émettra de la lumière autour et à travers le plot de contact. Si le dépôt de conducteur est épais, il sera nécessaire de graver en peignes la structure d'où, après passivation avec de l'oxyde, sortira la lumière le long du périmètre développé.

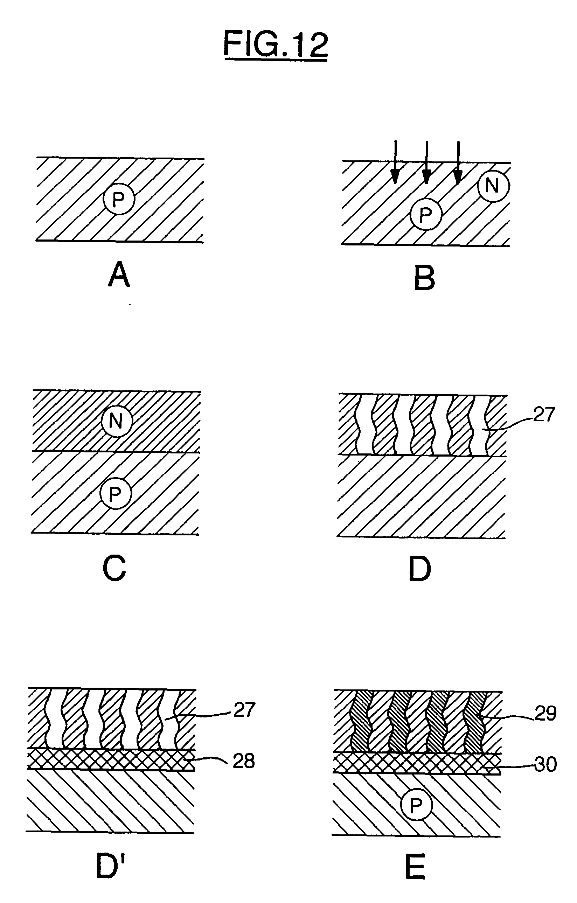

La figure 11 représente une structure en relief conforme à l'hypothèse d'obstruation des cavités avant que celle-ci ne puisse être remplie, formulée plus haut dans la description que l'on obtiendrait par certains procédés de l'art antérieur. La structure en relief (23) a été formée sur un substrat massif (22) par des méthodes classiques telles que par exemple l'électrochimie, de sorte que ces crystallites (24) soient toutes orientées verticalement dans la même direction. La structure a été soumise à un procédé de remplissage par une substance chimique (25) selon l'art antérieur laissant subsister des espaces vides (28) à l'intérieur de la structure du fait de la formation d'un bouchon (26) au dessus des cavités avant que celles-ci n'aient pu être remplies.

La figure 12 illustre la fabrication de diodes électroluminescentes conforme à l'invention, selon les étapes A à E illustrées sur la figure 12.

Après implantation d'un dopant N (B) sur un substrat P et recuit d'activation des dopants (C) ou inversement, on réalise une attaque électrochimique (D) qui fabrique du Si poreux de faible porosité (27) (typiquement 30%) sur la couche N pour la laisser conductrice, et du Si poreux de forte porosité supérieure ou égale à 70% (D') qui sera la zone de recombinaison (28) des proteurs injectés dans la diode NP. Ceci conduit à des diodes électroluminescentes émettant dans le rouge, mais sensibles au vieillissement car il n'y a pas de passivation. L'eau et l'oxygène rentrent dans les réseaux des pores et les détériorent par dégradation de la surface spécifique exposée.

On procède conformément à l'invention (E) au rebouchage des trous de la couche N par un dépôt N+, comme décrit ci-dessus par remplissage (29) et tapissage (30) par CVD.

Les structures résultant de la mise en oeuvre du procédé de l'invention peuvent être utilisées, par exemple, dans la fabrication de substrats à paramètre de maille variable pour toute épitaxie ultérieure, fabrication de détecteurs et d'émetteurs de lumière autres que ceux décrits précédemment, fabrication de capteurs d'impureté...

Les exemples qui suivent servent à illustrer la présente invention sans présenter un caractère limitatif.

### Exemple 1

### Procédé de fabrication d'une diode électroluminescente.

Sur un substrat de silicium massif dopé P, on épitaxie une couche de silicium dopée P+ dans laquelle on fabrique une couche d'environ 500 nm de silicium poreux de porosité de 80-85 % par électrochimie.

La couche poreuse est stabilisée dans un premier temps par un rinçage dans l'eau déionisée pendant environ 15 mn.

On introduit rapidement la plaquette de silicium poreux dans un réacteur pour éviter une oxydation non contrôlée de la surface interne du silicium poreux.

On introduit ensuite les gaz précurseurs de Si, Ge et de dopant N, de manière à obtenir un mélange gazeux composé de SiH₄, GeH₄, PH₃, AsH₃. On établit une pression à l'intérieur du réacteur égale à environ 14 Pa (100 m torrs). On augmente la température à l'intérieur du réacteur jusqu'à ce que l'on obtienne une température de 550°C.

Le procédé de remplissage des pores du silicium poreux est suivit par éllipsométrie spectroscopique in-situ. On laisse se poursuivre le dépôt par décomposition en phase gazeuse jusqu'à la formation d'une couche épitaxiale d'une épaisseur de 20 nm sur le réseau de pores comblés pour prendre un contact. On dépose ensuite une fine couche d'un conducteur sur cette couche épitaxiale. On obtient une diode électroluminescente N-P.

### Exemple 2

### Procédé de fabrication de multi-puits quantiques.

Sur un substrat massif de silicium peu dopé N on épitaxie une couche dopée N⁺ dans laquelle on forme par électrochimie une couche de silicium poreux de 50 % de porosité et d'une épaisseur de 500 nm.

On introduit rapidement la plaquette de silicium poreux dans un réacteur CVD pour éviter une oxydation non contrôlée de la surface interne du silicium poreux.

On introduit ensuite un mélange de gaz précurseurs composé de SiH₄, B₂H₆, GeH₄, puis on instaure une pression d'environ 14 Pa (100 m torrs) dans le réacteur CVD. On augmente la température jusqu'à atteindre une température de 550°C. Le dépôt par décomposition en phase gazeuse est poursuivit pendant environ 4 mn. On peut suivre le tapissage des parois des pores par éllipsométrie-spectroscopique insitu.

On obtient des multi-puits quantiques composés de silicium poreux dont la totalité de la surface spécifique est recouverte d'une monocouche de 2 nm d'épaisseur d'un alliage de Si_{0,85} Ge_{0,15} dopés P+ et absorbant dans la bande de longueur d'ondes de 9 à 12 nm.
Ce qui précède est fait pour une couche.
Bien entendu, on peut aussi rajouter en alternance d'autres couches.

## Revendications

1. Procédé pour tapisser ou remplir de façon homogène et uniforme une couche de silicium poreux dopée ou non, de porosité contrôlée et possédant un réseau de pores isotropes ou anisotropes avec un rapport d'aspect élevé supérieur à 2 et de période très faible inférieure à 500 nm, dans lequel on dépose au sein de cette couche de silicium poreux au moins une espèce chimique semi-conductrice dopée ou non, ou isolante choisie parmi
le silicium ;
les alliages à base de silicium du type
Si_{1-x-y-z-t} Geₓ C_{y} A_{z} Eₜ ; (E)ᵥ avec x, y, z et t désignant une valeur telle que 0 < x + y + z + t < 1 et 0 ≤ x < 1, 0 ≤ y < 1, 0 ≤ z < 1, 0 ≤ t < 1, 0 ≤ v ≤ 1, et v désignant la fraction de E présente éventuellement dans la matière sous forme interstitielle,
A désignant un métal et E une terre rare;
les oxydes de silicium ; et
les nitrures de silicium
ladite espèce chimique possédant un taux de croissance inférieur ou égal à 10 nm/mn, par décomposition en phase gazeuse de gaz précurseurs de cette espèce chimique dans un réacteur CVD.

2. Procédé selon la revendication 1, caractérisé en ce que la température de décomposition en phase gazeuse est inférieure ou égale à 750°C.

3. Procédé selon la revendication 1 ou 2, caractérisé en ce que la pression dans le réacteur CVD lors de la décomposition en phase gazeuse est inférieure ou égale à environ 14 Pa (100 m torrs).

4. Procédé selon l'une quelconque des revendications 1 à 3, caractérisé en ce que les gaz précurseurs sont introduits dans le réacteur CVD avant la montée en température.

5. Procédé selon l'une quelconque des revendications 1 à 4, caractérisé par le fait que les gaz précurseurs sont choisis parmi SiH₄, Si₂H₆, GeH₄, Si(CH₃)₄, en présence éventuellement de gaz dopants et/ou d'un gaz diluant.

6. Procédé selon la revendication 5, caractérisé par le fait que les gaz dopants sont choisis parmi PH₃, AsH₃, B₂H₆.

7. Procédé selon la revendication 5 ou 6, caractérisé par le fait que l'on utilise en mélange O₂, NH₃, N₂O ou d'autres gaz nitrés ou oxygénés pour obtenir des dépôts Si O₂ ou oxynitrures.

8. Procédé selon l'une quelconque des revendications 5 à 7, caractérisé par le fait que l'on utilise en plus des quantités faibles de gaz organométalliques ou de terres rares.

9. Procédé selon l'une quelconque des revendications 1 à 8, caractérisé en ce que l'on dépose successivement des espèces chimiques différentes en modifiant la nature du mélange gazeux dans le réacteur entre chaque dépôt.

10. Procédé selon l'une des revendications 1 à 9, caractérisé en ce que la structure en relief est soumise à une préoxydation avant la mise en oeuvre du tapissage ou du remplissage.

11. Procédé selon l'une quelconque des revendications 1 à 10, caractérisé en ce que l'étape de remplissage est suivie d'une épitaxie ou d'un dépôt d'une couche de même composition sur le réseau de pores comblés.

12. Procédé selon l'une quelconque des revendications 1 à 11, caractérisé en ce que y est différent de 0.

13. Procédé selon l'une quelconque des revendications 1 à 11, caractérisé en ce que t est différent de 0 et E représente l'erbium.

14. Procédé selon l'une quelconque des revendications 1 à 13, caractérisé en ce que la température de décomposition en phase gazeuse est inférieure ou égale à 600°C.

15. Procédé selon l'une quelconque des revendications 1 à 14, caractérisé en ce que le silicium poreux a une porosité supérieure ou égale à 75 %.

16. Procédé selon l'une quelconque des revendications 1 à 15, caractérisé en ce que l'on dépose sur la totalité de la surface spécifique développée par le silicium poreux une espèce chimique jusqu'à ce que les pores du réseau soient remplies, et en ce qu'on poursuit la réaction jusqu'à formation d'une couche épitaxiale sur le réseau de pores comblés.

17. Procédé selon la revendication 1 à 16, caractérisé en ce que l'espèce chimique déposée dans les pores du silicium poreux, est un semi-conducteur inversement dopé par rapport au silicium poreux.

18. Procédé selon la revendication 17, caractérisé en ce que le silicium poreux est dopé P et l'espèce chimique est dopée N.

19. Elément composé d'au moins une couche de silicium poreux dopée ou non, de porosité contrôlée et possédant un réseau de pores isotropes ou anisotropes avec un rapport d'aspect élevé supérieur à 2 et de période très faible inférieure à 500 nm et d'au moins une espèce chimique semi-conductrice dopée ou non ou isolante déposée au sein de la couche de silicium poreux et choisie parmi
le silicium ;
les alliages à base de silicium du type
Si_{1-x-y-z-t} Geₓ C_{y} A_{z} Eₜ ; (E)ᵥ avec x, y, z et t désignant une valeur telle que 0 < x + y + z + t < 1 et 0 ≤ x < 1, 0 ≤ y < 1, 0 ≤ z < 1, 0 ≤ t < 1, 0 ≤ v ≤ 1, et v désignant la fraction de E présente éventuellement dans la matière sous forme interstitielle,
A désignant un métal et E une terre rare;
les oxydes de silicum ; et
les nitrures de silicium.

20. Diode électroluminescente à base de silicium poreux dopé de porosité contrôlée et possédant un réseau de pores isotropes ou anisotropes avec un rapport d'aspect élevé supérieur à 2 et de période très faible inférieure à 500 nm, dans laquelle les pores du réseau sont remplis d'une espèce chimique semiconductrice inversement dopée par rapport au silicium poreux, déposée dans les pores du réseau et choisie parmi le silicium ;
les alliages à base de silicium du type
Si_{1-x-y-z-t} Geₓ C_{y} A_{z} Eₜ ; (E)ᵥ avec x, y, z et t désignant une valeur telle que 0 < x + y + z + t < 1 et 0 ≤ x < 1, 0 ≤ y < 1, 0 ≤ z < 1, 0 ≤ t < 1, 0 ≤ v ≤ 1, et v désignant la fraction de E présente éventuellement dans la matière sous forme interstitielle,
A désignant un métal et E une terre rare;
les oxydes de silicum ; et
les nitrures de silicium et en ce que le réseau de pores ainsi comblés est surmonté d'une couche épitaxiale sur laquelle est déposée un contact métallique.

21. Diode électroluminescente selon la revendication 20, caractérisée en ce que le silicium poreux à une porosité supérieure ou égale à 75 %.

22. Diode électroluminescente selon la revendication 20 ou 21, caractérisée en ce que le silicium poreux est dopé P et la substance chimique est dopée N.

23. Multi-puits quantiques, constitués d'une couche de silicium poreux obtenable par électrochimie, dopée ou non de porosité contrôlée et possédant un réseau de pores isotropes ou anisotropes, avec un rapport d'aspect supérieur à 2 et de période très petite inférieure à 500 nm, dont la totalité de la surface spécifique développée par la couche poreuse est tapissée d'au moins une couche d'une espèce chimique semi-conductrice dopée ou non, ou isolante choisie parmi
le silicium ;
les alliages à base de silicium du type
Si_{1-x-y-z-t} Geₓ C_{y} A_{z} Eₜ ; (E)ᵥ avec x, y, z et t désignant une valeur telle que 0 < x + y + z + t < 1 et 0 ≤ x < 1, 0 ≤ y < 1, 0 ≤ z < 1, 0 ≤ t < 1, 0 ≤ v ≤ 1, et v désignant la fraction de E présente éventuellement dans la matière sous forme interstitielle,
A désignant un métal et E une terre rare;
les oxydes de silicum ; et
les nitrures de silicium.

24. Multi-puits quantiques selon la revendication 23, caractérisés en ce que la surface spécifique développée par le silicium poreux est tapissée d'une multi-couche composée de couches de nature différente.

25. Multi-puits quantiques selon l'une quelconque les revendications 23 et 24, caractérisé en ce que le réseau de pores est isotrope.

26. Détecteur de lumière comportant des multi-puits quantiques tels que définis dans l'une quelconque des revendications 23 à 25.

## Patentansprüche

1. Verfahren zum homogenen und gleichförmigen Bedecken oder Füllen einer dotierten oder undotierten porösen Siliziumschicht mit einer gesteuerten Porösität, welche ein isotropes oder anisotropes poröses Gitter mit einem erhöhten Aspektverhältnis größer als 2 und einer sehr niedrigen Periode von kleiner als 500 nm aufweist, wobei bei dem Verfahren innerhalb dieser porösen Siliziumschicht zumindest eine dotierte oder undotierte halbleitende oder isolierende chemische Substanz abgeschieden wird, welche aus Silizium;
Legierungen auf Siliziumbasis des Typs Si_{1-x-y-z-t} Geₓ C_{y} A_{z} Eₜ, (E)ᵥ wobei x, y, z und t derartige Werte haben, daß 0 < x + y + z + t < 1 und 0 ≤ x < 1, 0 ≤ y < 1, 0 ≤ z < 1, 0 ≤ t < 1, 0 ≤ v ≤ 1 ist, und v den Bruchteil von E bezeichnet, der eventuell als Zwischengitteratom in der Substanz vorliegt, wobei A ein Metall und E eine seltene Erde bezeichnet;
Siliziumoxiden; oder
Siliziumnitriden ausgewählt ist,
und die chemische Substanz aufgrund der Zersetzung in der Gasphase von Gasprecursoren dieser chemischen Substanz in einem CVD-Reaktor eine Wachstumsrate von kleiner oder gleich 10 nm/min hat.

2. Verfahren nach Anspruch 1, wobei die Zersetzungstemperatur in der Gasphase kleiner oder gleich 750°C ist.

3. Verfahren nach Anspruch 1 oder 2, wobei der Druck im CVD-Reaktor während der Zersetzung in der Gasphase kleiner oder gleich ungefähr 14 Pa (100 mTorr) ist.

4. Verfahren nach einem der Ansprüche 1 bis 3, wobei die Gasprecursoren vor dem Temperaturanstieg in den CVD-Reaktor eingeführt werden.

5. Verfahren nach einem der Ansprüche 1 bis 4, wobei die Gasprecursoren aus SiH₄, Si₂H₆, GeH₄, Si(CH₃)₄ eventuell in Gegenwart eines Dotiergases und/oder eines Verdünnungsgases ausgewählt werden.

6. Verfahren nach Anspruch 5, wobei die Dotiergase aus PH₃, AsH₃, B₂H₆ ausgewählt werden.

7. Verfahren nach Anspruch 5 oder 6, wobei Mischungen von O₂, NH₃, N₂O oder anderen nitrierenden oder oxidierenden Gasen verwendet werden, um Abscheidungen von SiO₂ oder Stickstoffoxiden zu erhalten.

8. Verfahren nach einem der Ansprüche 5 bis 7, wobei zusätzlich geringe Mengen an organometallischen Gasen oder seltenen Erden verwendet werden.

9. Verfahren nach einem der Ansprüche 1 bis 8, wobei nacheinander verschiedene chemische Substanzen abgeschieden werden, indem die Gasgemischart im Reaktor zwischen jeder Abscheidung verändert wird.

10. Verfahren nach einem der Ansprüche 1 bis 9, wobei die Reliefstruktur vor der Durchführung des Bedeckens oder des Füllens einer Voroxidation unterzogen wird.

11. Verfahren nach einem der Ansprüche 1 bis 10, wobei auf den Füllschritt ein Epitaxieschritt oder ein Abscheidungsschritt einer Schicht mit derselben Zusammensetzung auf das ausgefüllte, poröse Gitter folgt.

12. Verfahren nach einem der Ansprüche 1 bis 11, wobei y von 0 verschieden ist.

13. Verfahren nach einem der Ansprüche 1 bis 11, wobei t von 0 verschieden ist und E für Erbium steht.

14. Verfahren nach einem der Ansprüche 1 bis 13, wobei die Zersetzungstemperatur in der Gasphase kleiner oder gleich 600°C ist.

15. Verfahren nach einem der Ansprüche 1 bis 14, wobei das poröse Silizium eine Porösität von größer oder gleich 75% aufweist.

16. Verfahren nach einem der Ansprüche 1 bis 15, wobei auf der gesamten durch das poröse Silizium ausgebildeten spezifischen Oberfläche eine chemische Substanz zur Füllung der Poren des Gitters abgeschieden wird und wobei die Reaktion bis zur Ausbildung einer epitaktischen Schicht auf dem ausgefüllten porösen Gitter fortgeführt wird.

17. Verfahren nach einem der Ansprüche 1 bis 16, wobei die in die Poren des porösen Siliziums abgeschiedene chemische Substanz ein Halbleiter mit zu dem porösen Silizium entgegengesetzter Dotierung ist.

18. Verfahren nach Anspruch 17, wobei das poröse Silizium p-dotiert und die chemische Substanz n-dotiert ist.

19. Vorrichtung mit zumindest einer Schicht aus dotiertem oder undotiertem porösem Silizium mit gesteuerter Porösität, welche ein isotropes oder anisotropes poröses Gitter mit einem erhöhten Aspektverhältnis größer als 2 und einer sehr niedrigen Periode von kleiner als 500 nm aufweist
und zumindest einer dotierten oder undotierten halbleitenden oder isolierenden chemischen Substanz, welche innerhalb dieser porösen Siliziumschicht abgeschieden ist und aus Silizium;
Legierungen auf Siliziumbasis des Typs Si_{1-x-y-z-t} Geₓ C_{y} A_{z} Eₜ, (E)ᵥ wobei x, y, z und t derartige Werte haben, daß 0 < x + y + z + t < 1 und 0 ≤ x < 1, 0 ≤ y < 1, 0 ≤ z < 1, 0 ≤ t < 1, 0 ≤ v ≤ 1 ist, und v den Bruchteil von E bezeichnet, der eventuell als Zwischengitteratom in der Substanz vorliegt; wobei A ein Metall und E eine seltene Erde bezeichnet;
Siliziumoxiden; oder
Siliziumnitriden ausgewählt ist.

20. Elektrolumineszenzdiode auf der Basis von porösem dotiertem Silizium mit gesteuerter Porösität, welches ein isotropes oder anisotropes poröses Gitter mit einem erhöhten Aspektverhältnis größer als 2 und einer sehr niedrigen Periode von kleiner als 500 nm aufweist,
wobei die Poren des Gitters mit einer in die Poren des Gitters abgeschiedenen chemischen Substanz aufgefüllt sind, welche ein Halbleiter mit zu dem porösen Silicium entgegengesetzter Dotierung ist und aus Silizium;
Legierungen auf Siliziumbasis des Typs Si_{1-x-y-z-t} Geₓ C_{y} A_{z} Eₜ, (E)ᵥ wobei x, y, z und t derartige Werte haben, daß 0 < x + y + z + t < 1 und 0 ≤ x < 1, 0 ≤ y < 1, 0 ≤ z < 1, 0 ≤ t < 1, 0 ≤ v ≤ 1 ist, und v den Bruchteil von E bezeichnet, der eventuell als Zwischengitteratom in der Substanz vorliegt; wobei A ein Metall und E eine seltene Erde bezeichnet;
Siliziumoxiden; oder
Siliziumnitriden ausgewählt ist;
und bei der auf das Gitter der derart aufgefüllten Poren eine Epitaxieschicht aufgebracht ist, auf der ein metallischer Kontakt angebracht ist.

21. Elektrolumineszenzdiode nach Anspruch 20, wobei das poröse Silizium eine Porösität größer oder gleich 75% aufweist.

22. Elektrolumineszenzdiode nach Anspruch 20 oder 21, wobei das poröse Silizium p-dotiert ist und die chemische Substanz n-dotiert ist.

23. Mehrfachquantentöpfe mit einer elektrochemisch geschaffenen Schicht aus porösem, dotiertem oder undotiertem Silizium, welche ein isotropes oder anisotropes poröses Gitter mit einem Aspektverhältnis größer als 2 und einer sehr niedrigen Periode von kleiner als 500 nm aufweist, wobei deren gesamte spezifische Oberfläche, die durch die poröse Schicht gebildet wird, mit zumindest einer dotierten oder undotierten halbleitenden oder isolierenden chemischen Substanz bedeckt ist, die aus Silizium;
Legierungen auf Siliziumbasis des Typs Si_{1-x-y-z-t} Geₓ C_{y} A_{z} Eₜ, (E)ᵥ wobei x, y, z und t derartige Werte haben, daß 0 < x + y + z + t < 1 und 0 ≤ x < 1, 0 ≤ y < 1, 0 ≤ z < 1, 0 ≤ t < 1, 0 ≤ v ≤ 1 ist, und v den Bruchteil von E bezeichnet, der eventuell als Zwischengitteratom in der Substanz vorliegt; wobei A ein Metall und E eine seltene Erde bezeichnet;
Siliziumoxiden; oder
Siliziumnitriden ausgewählt ist.

24. Mehrfachquantentöpfe nach Anspruch 23, wobei die durch das poröse Silizium ausgebildete spezifische Oberfläche mit einer aus Schichten unterschiedlicher Beschaffenheit zusammengesetzten Mehrfachschicht bedeckt ist.

25. Mehrfachquantentöpfe nach einem der Ansprüche 23 und 24, wobei das poröse Gitter isotrop ist.

26. Lichtdetektor mit Mehrfachquantentöpfen gemäß einem der Ansprüche 23 bis 25.

## Claims

1. A process for coating or filling, in homogeneous and uniform manner, a layer of porous silicon, which may or may not be doped, is of controlled porosity and comprises a network of isotropic or anisotropic pores with a high aspect ratio greater than 2 and very low periodicity of less than 500 nm, in which process there is deposited within said porous silicon layer at least one semi-conducting chemical species, which may or may not be doped, or insulating, selected from
silicon;
silicon-based alloys of the type
Si_{1-x-y-z-t} Geₓ C_{y} A_{z} Eₜ; (E)ᵥ, with x, y, z and t denoting a value such as 0 < x + y + z + t < 1 and 0 ≤ x < 1, 0 ≤ y < 1, 0 ≤ z < 1, 0 ≤ t < 1, 0 ≤ v ≤ 1, and v denoting the fraction of E optionally present in the material in interstitial form,
A denoting a metal and E a rare earth;
silicon oxides; and
silicon nitrides,
said chemical species exhibiting a rate of growth lower than or equal to 10 nm/mn, by gaseous phase decomposition of gases constituting precursors of this chemical species in a CVD reactor.

2. A process according to claim 1, characterised in that the gaseous phase decomposition temperature is lower than or equal to 750°C.

3. A process according to claim 1 or claim 2, characterised in that the pressure in the CVD reactor at the time of gaseous phase decomposition is lower than or equal to approximately 14 Pa (100 m torrs).

4. A process according to any one of claims 1 to 3, characterised in that the precursor gases are introduced into the CVD reactor prior to the temperature increase.

5. A process according to any one of claims 1 to 4, characterised in that the precursor gases are selected from SiH₄, Si₂H₆, GeH₄, Si(CH₃)₄, optionally in the presence of doping gases and/or a diluting gas.

6. A process according to claim 5, characterised in that the doping gases are selected from PH₃, AsH₃, B₂H₆.

7. A process according to claim 5 or claim 6, characterised in that a mixture of O₂, NH₃, N₂O or other nitrated or oxygenated gases is used to obtain SiO₂ or oxynitride deposits.

8. A process according to any one of claims 5 to 7, characterised in that small amounts of organometallic gases or rare earths are additionally used.

9. A process according to any one of claims 1 to 8, characterised in that different chemical species are deposited in succession by modifying the nature of the gaseous mixture in the reactor between each deposit.

10. A process according to any one of claims 1 to 9, characterised in that the relief structure is subjected to preoxidation prior to carrying out the coating or filling.

11. A process according to any one of claims 1 to 10, characterised in that the filling stage is followed by epitaxy or the deposition of a layer of the same composition on the network of stopped pores.

12. A process according to any one of claims 1 to 11, characterised in that y is different from 0.

13. A process according to any one of claims 1 to 11, characterised in that t is different from 0 and E represents erbium.

14. A process according to any one of claims 1 to 13, characterised in that the gaseous phase decomposition temperature is lower than or equal to 600°C.

15. A process according to any one of claims 1 to 14, characterised in that the porous silicon has a porosity greater than or equal to 75 %.

16. A process according to any one of claims 1 to 15, characterised in that a chemical species is deposited over the entire specific surface area developed by the porous silicon until the pores of the network are full, and in that the reaction is carried out until an epitaxial layer is formed on the network of stopped pores.

17. A process according to claims 1 to 16, characterised in that the chemical species deposited in the pores of the porous silicon is a semi-conductor inversely doped with respect to the porous silicon.

18. A process according to claim 17, characterised in that the porous silicon is P doped and the chemical species is N doped.

19. An element composed of at least one layer of porous silicon, which may or may not be doped, is of controlled porosity and comprises a network of isotropic or anisotropic pores with a high aspect ratio greater than 2 and a very low periodicity of less than 500 nm, and of at least one semi-conducting chemical species, which may or may not be doped, or insulating, is deposited within said porous silicon layer and is selected from
silicon;
silicon-based alloys of the type
Si_{1-x-y-z-t} Geₓ C_{y} A_{z} Eₜ; (E)ᵥ, with x, y, z and t denoting a value such as 0 < x + y + z + t < 1 and 0 ≤ x < 1, 0 ≤ y < 1, 0 ≤ z < 1, 0 ≤ t < 1, 0 ≤ v ≤ 1, and v denoting the fraction of E optionally present in the material in interstitial form,
A denoting a metal and E a rare earth;
silicon oxides; and
silicon nitrides.

20. An electroluminescent diode based on doped porous silicon, the doped porous silicon being of controlled porosity and comprising a network of isotropic or anisotropic pores with a high aspect ratio greater than 2 and a very low periodicity of less than 500 nm, in which diode the pores of the network are filled with a semiconducting chemical species which is inversely doped with respect to the porous silicon, is deposited in the pores of the network and is selected from
silicon;
silicon-based alloys of the type
Si_{1-x-y-z-t} Geₓ C_{y} A_{z} Eₜ; (E)ᵥ, with x, y, z and t denoting a value such as 0 < x + y + z + t < 1 and 0 ≤ x < 1, 0 ≤ y < 1, 0 ≤ z < 1, 0 ≤ t < 1, 0 ≤ v ≤ 1, and v denoting the fraction of E optionally present in the material in interstitial form,
A denoting a metal and E a rare earth;
silicon oxides; and
silicon nitrides, and in that the network of pores thus stopped is surmounted by an epitaxial layer on which there is deposited a metal contact.

21. An electroluminescent diode according to claim 20, characterised in that the porous silicon has a porosity greater than or equal to 75 %.

22. An electroluminescent diode according to claim 20 or claim 21, characterised in that the porous silicon is P doped and the chemical substance is N doped.

23. Quantum multi-wells consisting of a layer of porous silicon which may be obtained by electrochemistry, may or may not be doped, is of controlled porosity and comprises a network of isotropic or anisotropic pores with a high aspect ratio greater than 2 and a very low periodicity of less than 500 nm, and whose entire specific surface area, developed by the porous layer, is coated with at least one layer of a semi-conducting chemical species, which may or may not be doped, or insulating, selected from
silicon;
silicon-based alloys of the type
Si_{1-x-y-z-t} Geₓ C_{y} A_{z} Eₜ; (E)ᵥ, with x, y, z and t denoting a value such as 0 < x + y + z + t < 1 and 0 ≤ x < 1, 0 ≤ y < 1, 0 ≤ z < 1, 0 ≤ t < 1, 0 ≤ v ≤ 1, and v denoting the fraction of E optionally present in the material in interstitial form,
A denoting a metal and E a rare earth;
silicon oxides; and
silicon nitrides.

24. Quantum multi-wells according to claim 23, characterised in that the specific surface area developed by the porous silicon is coated by a multilayer composed of layers of different natures.

25. Quantum multi-wells according to either one of claims 23 and 24, characterised in that the network of pores is isotropic.

26. A light detector comprising quantum multi-wells such as defined in any one of claims 23 to 25.
